# EUROPEAN PATENT APPLICATION

(11) **EP 4 531 121 A1**
(43) Date of publication of application: **02.04.2025**
(21) Application number: 24179237.3
(22) Date of filing: 31.05.2024
(51) Int. Cl.: H01L 33/50, H01L 33/16, H01L 33/22, H01L 33/00, H01L 33/20, H01L 25/075

(54) **NANOROD LIGHT-EMITTING DEVICE, METHOD OF MANUFACTURING THE SAME, AND DISPLAY APPARATUS INCLUDING THE NANOROD LIGHT-EMITTING DEVICE**

(30) Priority: 27.09.2023 KR 20230131167
(71) Applicant: Samsung Electronics Co., Ltd., Suwon-si, Gyeonggi-do 16677 (KR)
(72) Inventor: KIM, Nakhyun, 16678 Suwon-si (KR); CHOI, Junhee, 16678 Suwon-si (KR); HAN, Joohun, 16678 Suwon-si (KR)
(74) Representative: Elkington and Fife LLP

(57) **Abstract**

A nanorod light-emitting device includes an n-type semiconductor layer, an active layer on the n-type semiconductor layer, and a p-type semiconductor layer on the active layer, and the n-type semiconductor layer includes a core rod, a plurality of nano pores opened in an outward direction from the core rod, and a plurality of quantum dots dispersed in the plurality of nano pores.

## Description

### FIELD OF THE INVENTION

The disclosure relates to a nanorod light-emitting device with improved luminous efficiency, a method of manufacturing the same, and a display apparatus including the nanorod light-emitting device.

### BACKGROUND OF THE INVENTION

Light-emitting diodes (LEDs) are known as next-generation light sources with advantages such as long lifespan, low power consumption, fast response speeds, environmental friendliness, and the like, compared with existing light sources, and the industrial demand thereof is increasing due to these advantages. LEDs have typically been applied and used for various products, such as lighting devices and backlights of display apparatuses.

Recently, ultra-small LEDs in units of micro units or nano units using Group II-VI or Group III-V compound semiconductors have been developed. Furthermore, micro LED displays directly employing such ultra-small LEDs as light-emitting elements of display pixels have been developed. However, when LEDs are miniaturized in micro units or nano units, luminous efficiency thereof deteriorates.

### SUMMARY OF THE INVENTION

According to an aspect of the disclosure, there is a nanorod light-emitting device including: an n-type semiconductor layer; an active layer on the n-type semiconductor layer; and a p-type semiconductor layer on the active layer, and the n-type semiconductor layer includes a core rod, a plurality of nano pores opened in an outward direction from the core rod, and a plurality of quantum dots dispersed in the plurality of nano pores.

In a cross-section of the n-type semiconductor layer, the plurality of nano pores may be arranged radially from the core rod.

In a vertical cross-section of the n-type semiconductor layer, the plurality of nano pores may be arranged in a vertical direction.

The active layer may include at least one of indium gallium nitride (InGaN) and indium aluminum gallium nitride (InAlGaN).

The nanorod light-emitting device may include a diameter in a range of 0.5 µm to 2 µm.

The nanorod light-emitting device may include a height in a range of 2 µm to 7 µm.

A diameter of the core rod may be in a range of 1/3 to 1/5 of a diameter of the nanorod light-emitting device.

A diameter of the core rod may be in a range of 120 nm to 200 nm.

The plurality of quantum dots may be configured to convert blue light emitted by the active layer into red light.

The nanorod light-emitting device may further include a super lattice layer between the n-type semiconductor layer and the active layer.

The nanorod light-emitting device may further include a current blocking layer between the active layer and the p-type semiconductor layer.

Each of the plurality of nano pores may have a first length in a diametric direction of the n-type semiconductor layer and a second length in a direction perpendicular to the diametric direction, and the first length is greater than the second length.

According to an aspect of the disclosure, there is a display apparatus including: a plurality of pixel electrodes; a common electrode corresponding to the plurality of pixel electrodes; a plurality of nanorod light-emitting devices connected between each of the plurality of pixel electrodes and the common electrode; and a driving circuit layer configured to drive the plurality of nanorod light-emitting devices, and each of the plurality of nanorod light-emitting devices includes an n-type semiconductor layer, an active layer on the n-type semiconductor layer, and a p-type semiconductor layer on the active layer, and the n-type semiconductor layer includes a core rod, a plurality of nano pores opened in an outward direction from the core rod, and a plurality of quantum dots dispersed in the plurality of nano pores.

In a cross-section of the n-type semiconductor layer, the plurality of nano pores may be arranged radially from the core rod.

In a vertical cross-section of the n-type semiconductor layer, the plurality of nano pores may be arranged in a vertical direction.

The active layer may include at least one of indium gallium nitride (InGaN) and indium aluminum gallium nitride (InAlGaN).

According to an aspect of the disclosure, a method of manufacturing a nanorod light-emitting device includes: forming an n-type semiconductor layer on a substrate; forming an active layer on the n-type semiconductor layer; forming a p-type semiconductor layer on the active layer; forming a plurality of nanorod light-emitting structures by patterning the n-type semiconductor layer, the active layer, and the p-type semiconductor layer in a form of a plurality of nanorods; forming, by an electrochemical etching process and on the n-type semiconductor layer having the plurality of nanorod light-emitting structures, a core rod and a plurality of nano pores opened in an outward direction from the core rod; and encapsulating quantum dots in the plurality of nano pores.

In a cross-section of the n-type semiconductor layer, the plurality of nano pores may be arranged radially from the core rod.

In a vertical cross-section of the n-type semiconductor layer, the plurality of nano pores may be arranged in a vertical direction.

### BRIEF DESCRIPTION OF THE DRAWINGS

These and/or other aspects will become apparent and more readily appreciated from the following description, of the embodiments, taken in conjunction with the accompanying drawings in which:
FIG. 1 is a schematic view of a nanorod light-emitting device according to one or more embodiments;
FIG. 2 is a cross-sectional view of the nanorod light-emitting device taken along line A-A of FIG. 1;
FIG. 3 is a view showing an example in which the nanorod light-emitting device of FIG. 1 further includes a super lattice layer and an electron blocking layer;
FIG. 4 is a view showing an example in which the nanorod light-emitting device of FIG. 1 further includes a passivation film;
FIG. 5 illustrates part of a method of manufacturing a nanorod light-emitting device, according to one or more embodiments;
FIG. 6 illustrates part of a method of manufacturing a nanorod light-emitting device, according to one or more embodiments;
FIG. 7 illustrates part of a method of manufacturing a nanorod light-emitting device, according to one or more embodiments;
FIG. 8 illustrates part of a method of manufacturing a nanorod light-emitting device, according to one or more embodiments;
FIG. 9 illustrates part of a method of manufacturing a nanorod light-emitting device, according to one or more embodiments;
FIG. 10 illustrates part of a method of manufacturing a nanorod light-emitting device, according to one or more embodiments;
FIG. 11 illustrates part of a method of manufacturing a nanorod light-emitting device, according to one or more embodiments;
FIG. 12 illustrates part of a method of manufacturing a nanorod light-emitting device, according to one or more embodiments;
FIG. 13 illustrates part of a method of manufacturing a nanorod light-emitting device, according to one or more embodiments;
FIG. 14 illustrates part of a method of manufacturing a nanorod light-emitting device, according to one or more embodiments;
FIG. 15 illustrates part of a method of manufacturing a nanorod light-emitting device, according to one or more embodiments;
FIG. 16 illustrates part of a method of manufacturing a nanorod light-emitting device, according to one or more embodiments;
FIG. 17 is a schematic view of a display apparatus according to one or more embodiments;
FIG. 18 is a view showing an array layer of a display apparatus according to one or more embodiments;
FIG. 19 is a schematic block diagram of an electronic apparatus according to one or more embodiments;
FIG. 20 is a view showing an example in which a display apparatus according to one or more embodiments is applied to a mobile device;
FIG. 21 is a view showing an example in which a display apparatus according to one or more embodiments is applied to a display apparatus for a vehicle;
FIG. 22 is a view showing an example in which a display apparatus according to one or more embodiments is applied to augmented reality glasses;
FIG. 23 is a view showing an example in which a display apparatus according to one or more embodiments is applied to signage; and
FIG. 24 is a view showing an example in which a display apparatus according to one or more embodiments is applied to a wearable display.

### DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression "at least one of A and B" means only A, only B, or both A and B.

Hereinbelow, a nanorod light-emitting device, a method of manufacturing the same, and a display apparatus including the nanorod light-emitting device according to various embodiments are described in detail with reference to the accompanying drawings. Throughout the drawings, like reference numerals denote like elements, and sizes of components in the drawings may be exaggerated for convenience of explanation and clarity. Terms such as "first" and "second" are used herein merely to describe a variety of constituent elements, but the constituent elements are not limited by the terms. Such terms are used only for the purpose of distinguishing one constituent element from another constituent element.

As used herein, the singular forms "a," "an," and "the" are intended to include the plural forms as well, unless the context clearly indicates otherwise. When a part may "include" a certain constituent element, unless specified otherwise, it may not be construed to exclude another constituent element but may be construed to further include other constituent elements. Furthermore, the size or thickness of each constituent element illustrated in the drawings may be exaggerated for clarity of explanation. Furthermore, when a material layer is described to exist on another layer, the material layer may exist directly on the other layer or a third layer may be interposed therebetween. Since a material forming each layer in the following embodiments is exemplary, other materials may be used therefor.

Furthermore, In the disclosure, a "module" or "portion" may perform at least one of functions or operations, and may be implemented by hardware or software or a combination of hardware and software.

The particular implementations shown and described herein are illustrative examples of the disclosure and are not intended to otherwise limit the scope of the disclosure in any way. For the sake of brevity, conventional electronics, control systems, software development and other functional aspects of the systems may not be described in detail. Furthermore, the connecting lines, or connectors shown in the various figures presented are intended to represent functional relationships and/or physical or logical couplings between the various elements. It should be noted that many alternative or additional functional relationships, physical connections, or logical connections may be present in a practical device.

The use of the terms "a," "an," "the," and similar referents in the context of describing the disclosure are to be construed to cover both the singular and the plural.

The steps of all methods described herein can be performed in any suitable order unless otherwise indicated herein or otherwise clearly contradicted by context. Furthermore, the use of any and all examples, or language (e.g., "such as") provided herein, is intended merely to better illuminate the disclosure and does not pose a limitation on the scope of the disclosure unless otherwise claimed.

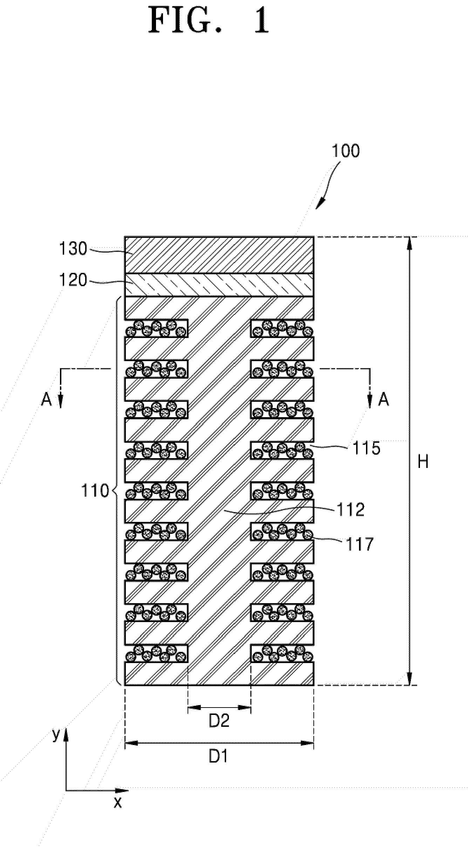

FIG. 1 illustrates a nanorod light-emitting device 100 according to one or more embodiments.

The nanorod light-emitting device 100 may include a first semiconductor layer 110, an active layer 120 provided on the first semiconductor layer 110, and a second semiconductor layer 130 provided on the active layer 120. The first semiconductor layer 110 and the second semiconductor layer 130 may each include a Group II-VI or Group III-V compound semiconductor material. The first semiconductor layer 110 and the second semiconductor layer 130 each provide electrons and holes to the active layer 120. To this end, the first semiconductor layer 110 may be doped to an n type or p type, and the second semiconductor layer 130 may be doped to a type electrically opposite to the type of the first semiconductor layer 110. For example, the first semiconductor layer 110 may be doped to an n type and the second semiconductor layer 130 may be doped to a p type, or the first semiconductor layer 110 may be doped to a p type and the second semiconductor layer 130 may be doped to an n type. When the first semiconductor layer 110 or the second semiconductor layer 130 is doped to an n type, for example, Si, Ge, or Sn may be used as a dopant, and when the first semiconductor layer 110 or the second semiconductor layer 130 is doped to a p type, for example, Mg, Zn, Ca, Se, or Ba may be used as a dopant. The first semiconductor layer 110 or the second semiconductor layer 130 doped to an n type may provide electrons to the active layer 120, and the second semiconductor layer 130 or the first semiconductor layer 110 doped to a p type may provide holes to the active layer 120. In the following description, a case in which the first semiconductor layer 110 is an n-type semiconductor layer and the second semiconductor layer 130 is a p-type semiconductor layer is described. The first semiconductor layer 110 may include a Group III-V-based n-type semiconductor, for example, n-GaN. The second semiconductor layer 130 may include a Group III-V-based p-type semiconductor, for example, p-GaN. The first semiconductor layer 110 and the second semiconductor layer 130 may each have a single layer or multilayer structure.

The active layer 120 may include a nitride semiconductor. For example, the active layer 120 may include a GaN-based material. In this case, the active layer 120 may include an undoped GaN-based material or a GaN-based material doped with certain impurities. For example, the active layer 120 may include InGaN or InAlGaN.

The active layer 120 may have a quantum well structure in which a quantum well is arranged between barriers. As the electrons and holes provided from the first semiconductor layer 110 and the second semiconductor layer 130 are recombined with each other in quantum wells in the active layer 120, light may be generated. The wavelength of light generated in the active layer 120 may be determined according to the energy bandgap of the material forming the quantum well in the active layer 120. The active layer 120 may have a single quantum well only, or a multi-quantum-well (MQW) structure in which a plurality of quantum wells and a plurality of barriers are alternately arranged. The thickness of the active layer 120 or the number of quantum wells in the active layer 120 may be appropriately selected considering the driving voltage, luminous efficiency, and the like of the nanorod light-emitting device 100. When the active layer 120 has a multi-quantum-well structure, for example, a quantum well structure including InGaN/GaN.

The nanorod light-emitting device 100 may have the form of a nanorod having a very small size of a nano scale or micro scale. For example, the nanorod light-emitting device 100 may have a diameter D1 of about 0.5 µm to about 2 µm. The diameter D1 may represent the maximum diameter when the diameter of the nanorod light-emitting device 100 is not uniform. The nanorod light-emitting device 100 may have an approximately uniform diameter along a height direction. For example, the diameters of the first semiconductor layer 110, the active layer 120, and the second semiconductor layer 130 may be substantially the same. Furthermore, assuming that a length from the lower surface of the first semiconductor layer 110 to the upper surface of the second semiconductor layer 130 is the height H of the nanorod light-emitting device 100, the height H may have a range of about 2 µm to about 7 µm. Furthermore, the nanorod light-emitting device 100 may have an aspect ratio of, for example, 4 or more. For example, the diameter D1 of the nanorod light-emitting device 100 may be selected to be about 600 nm, and the height H thereof may be selected to be about 5 µm. In this case, the aspect ratio of the nanorod light-emitting device 100 may be slightly greater than 8.

The first semiconductor layer 110 may include a core rod 112 and a plurality of nano pores 115 opened in an outward direction from the core rod 112. The core rod 112 may represent a central area of the first semiconductor layer 110 in which the nano pores 115 do not exist. The nanorod light-emitting device 100 may have a cylindrical structure. However, the shape of the nanorod light-emitting device 100 is not limited thereto, and the nanorod light-emitting device 100 may have various rod structure such as a square pillar, a pentagonal pillar, a hexagonal pillar, and the like. The first semiconductor layer 110 may have a relatively great height compared with the active layer 120 or the second semiconductor layer 130. The first semiconductor layer 110 may have a relatively large height compared with the diameter thereof.

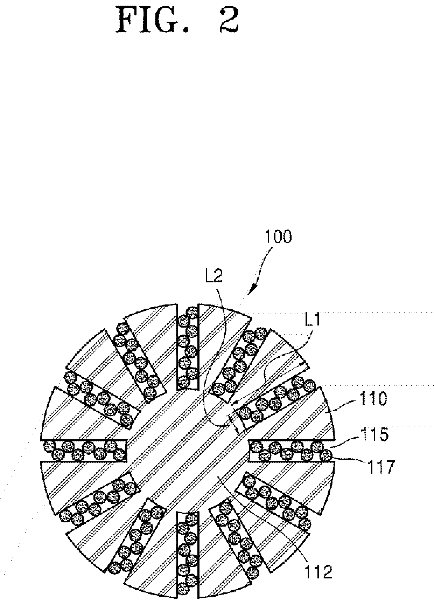

A diameter D2 of the core rod 112 may have a range of about 1/5 to about 1/3 of the diameter D1 of the nanorod light-emitting device 100. For example, the diameter D2 of the core rod 112 may have a range of about 120 nm to about 200 nm. FIG. 2 is a cross-sectional view of the nanorod light-emitting device 100 taken along line A-A of FIG. 1. The diameter D1 of the core rod 112 may represent the maximum diameter in any one cross-sectional area of the first semiconductor layer 110. The cross-sectional area represents a cross section obtained by cutting the nanorod light-emitting device 100 in a diametric direction (x direction), and a vertical cross-sectional area represent a cross section obtained by cutting the nanorod light-emitting device 100 in a height direction (y direction). Although FIG. 2 illustrates that the core rod 112 has an approximately circular cross-section, substantially, the cross-section of the core rod 112 may not be a perfect circle, but may have an oval or irregular shape. In this case, the diameter D2 of the core rod 112 may represent a distance between the nano pores 115 facing each other in a corresponding cross-section, and may represent the maximum diameter in the corresponding cross-section.

The core rod 112 secures an area having a certain diameter and function as a path in which current supplied to the nanorod light-emitting device 100 efficiently flows, thereby increasing electrical stability. Furthermore, the core rod 112 may be provided in a central area of the nanorod light-emitting device 100 to thus provide structural stability.

Referring to FIG. 2, the nano pores 115 are opened outwardly from the core rod 112. The nano pores 115 may be arranged radially from the core rod 112 when viewed from the cross-section of the first semiconductor layer 110. The nano pores 115 may be arranged at the outer portion of the first semiconductor layer 110 with respect to the core rod 112. Furthermore, the nano pores 115 may each have a shape in which a length L1 in a diametric direction of the first semiconductor layer 110 is relatively greater than a length L2 in a direction perpendicular to the diameter direction. Referring back to FIG. 1, the nano pores 115 may be arranged spaced apart from each other in the vertical direction (y direction) in the vertical cross-section of the first semiconductor layer 110.

A plurality of quantum dots 117 are dispersed in the nano pores 115. The quantum dots 117 each have a size of several nanometers, include an inorganic material, and have an energy bandgap of a specific wavelength, and thus, when absorbing light of energy higher than the energy bandgap, the quantum dots 117 emit light of a different wavelength, thereby performing color conversion. The quantum dots 117 each have a narrow emission wavelength band so as to increase the color reproduction of a display apparatus.

The quantum dots 117 may each have a core-shell structure of a core portion and a shell portion, or a shell-less particle structure. The core-shell structure may include a single-shell structure or a multi-shell, for example, a double-shell, structure.

The quantum dots 117 may include a Group II-VI-based semiconductor, a Group III-V-based semiconductor, a Group IV-VI-based semiconductor, a Group IV-based semiconductor, and/or graphene quantum dots. The quantum dots 117 may each include, for example, any one or more of Cd, Se, Zn, S, and InP and may each have a diameter of several tens of nanometers or less, for example, about 10 nm or less. The quantum dots 117 may each include a compound, for example, CdSe, CdTe, InP, InAs, InSb, PbSe, PbS, PbTe, AlAs, ZnS, ZnSe, ZnTe, graphene, and the like. The quantum dots 117 may each absorb light in a specific wavelength band and emit light in a wavelength band longer than that of the absorbed light. The wavelength of light absorbed by the quantum dots 117 may vary according to the energy bandgap of the quantum dots 117. The energy bandgap of the quantum dots 117 may vary according to the material or size thereof. The quantum dots 117 may each emit blue light according to the material or size thereof or emit green light or red light as being excited by an ultraviolet ray. For example, the quantum dots 117 may be configured to convert blue light emitted from the active layer 120 into red light.

When the active layer 120 includes indium (In), the more the content of In, the longer is the wavelength of light emitted from the active layer 120. For example, when the indium content of the active layer 120 is 15% or about 15%, the active layer 120 may emit blue light having a wavelength of 450 nm or about 450 nm; when the indium content of the active layer 120 is 25% or about 25%, the active layer 120 may emit green light having a wavelength of 520 nm or about 520 nm; and when the indium content of the active layer 120 is 35% or about 35%, the active layer 120 may emit red light having a wavelength of 630 nm or about 630 nm. The active layer 120 may emit blue light by adjusting the indium content of the active layer 120 to be 15% or about 15% or less.

When the nanorod light-emitting device 100 has a very small size of a nano scale, the external quantum efficiency (EQE) and internal quantum efficiency (IQE) of the active layer 120 may be reduced as an emission wavelength increases. Furthermore, as the indium content of the active layer 120 increases, defects due to lattice mismatch may increase. Accordingly, by configuring the active layer 120 to generate light in a short wavelength band with relatively high luminous efficiency and configuring the quantum dots 117 to convert and emit light having a relatively short wavelength into light having a relatively long wavelength, the luminous efficiency of the nanorod light-emitting device 100 may be improved.

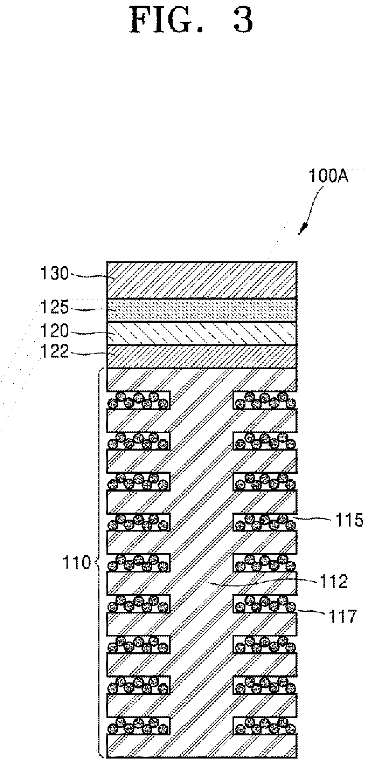

FIG. 3 is a view showing an example in which the nanorod light-emitting device 100 of FIG. 1 further includes a super lattice layer and an electron blocking layer. In FIG. 3, as the elements using the same reference numerals as those of FIG. 1 are substantially the same, detailed descriptions thereof are omitted.

A nanorod light-emitting device 100A may further include a super lattice layer 122 between the first semiconductor layer 110 and the active layer 120.

The super lattice layer 122 may include, for example, an InGaN/GaN super lattice layer, an AlN/GaN super lattice layer, or an AlₓIn_{y}Ga_{(1-x-y)}N/AlₓIn_{y}Ga_{(1-x-y)}N (0≤x,y≤1 and x≠y) super lattice layer. The super lattice layer 122 may reduce current spreading and strain below the active layer 120. The super lattice layer 122 has a structure in which a first layer and a second layer are alternately stacked, for example, an InGaN/GaN super lattice layer may include an InGaN layer and a GaN layer that are alternately arranged. The super lattice layer 122 may have a bandgap greater than that of the active layer 120 to prevent light from being emitted from or absorbed by the super lattice layer 122. For example, the active layer 120 may be formed by stacking 10 pairs of In₁₅Ga₇₅N/GaN layers each having a thickness of 5 nm / 5 nm, and the super lattice layer 122 may be formed by stacking 30 pairs of In₅Ga₉₅N/GaN layers each having a thickness of 1 nm / 1 nm. The super lattice layer 122 has an In content less than that of the active layer 120 and may be configured as a thin layer whose thickness is less than that of the active layer 120.

An electron blocking layer 125 may be provided between the active layer 120 and the second semiconductor layer 130. The electron blocking layer 125 may include AlGaN, AlInN, or AllnGaN. The electron blocking layer 125 may have a thickness of 3 nm or more. The electron blocking layer 125 may prevent tunneling so as to efficiently block the leakage of electrons.

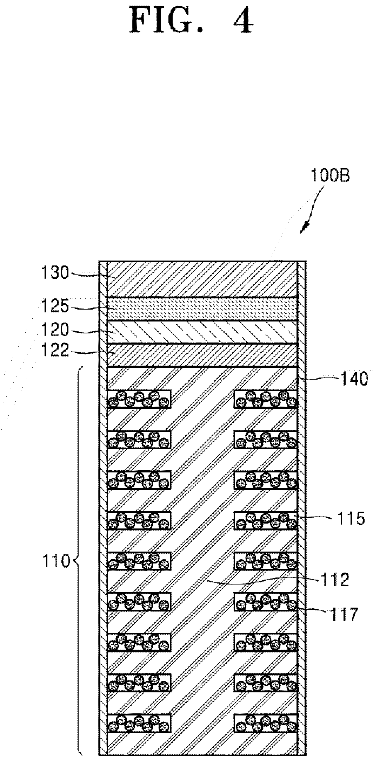

FIG. 4 is a view showing an example in which the nanorod light-emitting device 100 of FIG. 1 further includes a passivation film 140.

A nanorod light-emitting device 100B may further include the passivation film 140 on the side walls of the first semiconductor layer 110, the active layer 120 and, the second semiconductor layer 130.

The passivation film 140 may be formed by crystal growing a material having a structure similar to the active layer 120. In this case, the passivation film 140 may have an epitaxial relationship with the active layer 120. In other words, a hetero junction is formed at an interface between the passivation film 1140 and the active layer 120. The passivation film 140 may include an insulating crystal material having the same crystal structure as the crystal structure of the active layer 120. The passivation film 140 may have a lattice matching epitaxial relationship or a domain matching epitaxial relationship with the active layer 120. The lattice matching epitaxial relationship means a relationship that the lattice constant of the passivation film 140 is almost identical to the lattice constant of the active layer 120. Furthermore, the domain matching epitaxial relationship means a relationship that the lattice constant of the passivation film 140 is almost identical to an integer multiple of the lattice constant of the nanorod light-emitting device 100B or the lattice constant of the lattice constant of the nanorod light-emitting device 100B is almost identical to an integer multiple of the lattice constant of the passivation film 140. For example, a difference between a lattice constant m2 of the passivation film 140 and a lattice constant m1 of the nanorod light-emitting device 100B may be within ±30% of the lattice constant m1. Then, dangling bonds on the outer surface of the active layer 120 are removed, and thus, surface defects occurring on the outer surface of the active layer 120 may be removed. Accordingly, as the surface defects of the active layer 120 are recovered, the luminous efficiency of the nanorod light-emitting device 100B may be improved.

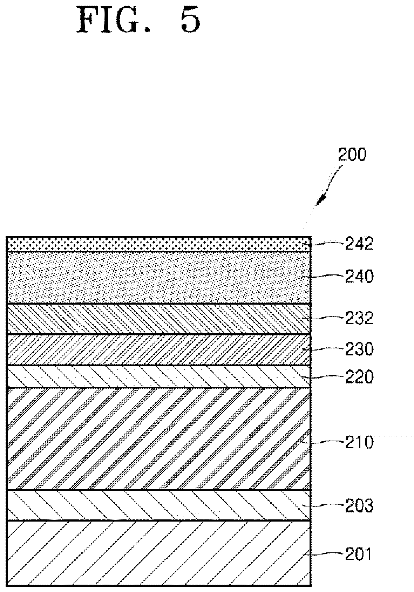

In the following description, a method of manufacturing a nanorod light-emitting device according to one or more embodiments is described with reference to FIG. 5, FIG. 6, FIG. 7, FIG. 8, FIG. 9, FIG. 10, FIG. 11, FIG. 12, FIG. 13, FIG. 14, FIG. 15, and FIG. 16.

Referring to FIG. 5, a first semiconductor layer 210, an active layer 220, and a second semiconductor layer 230 may be formed on a substrate 201. The first semiconductor layer 210 may be an n-type semiconductor layer and may include, for example, n-type GaN. The active layer 220 may have a single quantum-well structure or a multi-quantum-well structure. The active layer 220 may include InGaN or InAlGaN. The second semiconductor layer 230 may be a p-type semiconductor layer and may include, for example, p-type GaN. A sacrificial layer 203 may be formed between the substrate 201 and the first semiconductor layer 210.

The substrate 201 and the sacrificial layer 203 may include a Group II-VI or Group III-V compound semiconductor material. The substrate 201 and the sacrificial layer 203 may each be doped to the same conductive type as that of the first semiconductor layer 210. For example, when the first semiconductor layer 210 is doped to an n-type, the substrate 201 and the sacrificial layer 203 may each include n-GaAs. The substrate 201 may be doped to a lower concentration than that of the sacrificial layer 203, and the sacrificial layer 203 may be doped to a higher concentration than that of the substrate 201. A contact layer for ohmic contact may be further arranged between the sacrificial layer 203 and the first semiconductor layer 210. The contact layer between the sacrificial layer 203 and the first semiconductor layer 210 may be doped to the same conductive type to that of the first semiconductor layer 210 and to be higher than the doping concentration of each of the sacrificial layer 203 and the first semiconductor layer 210.

A contact layer 232 may be further formed on the second semiconductor layer 230. The contact layer 232 may be disposed on the second semiconductor layer 230 to provide an ohmic contact. The contact layer 232 may be doped to the same conductive type as that of the second semiconductor layer 230. For example, when the second semiconductor layer 230 is doped to a p-type, the contact layer 232 may be doped to the p-type. The contact layer 232 may include, for example, GaInP or GaAs. However, the contact layer 232 may be omitted according to one or more embodiments.

After the materials for forming a nanorod light-emitting device are stacked, by partially etching an epi wafer 200 in which the materials are stacked, a plurality of nanorod light-emitting devices may be manufactured. To this end, a first hard mask 240 and a second hard mask 242 may be formed on the contact layer 232.

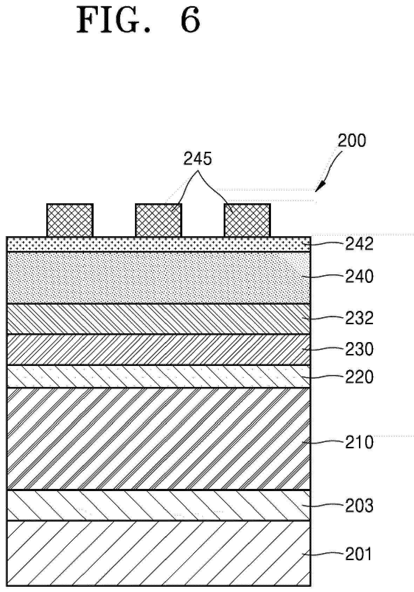

Referring to FIG. 6, a soft mask 245 may be formed on the second hard mask 242. The soft mask 245 may include photoresist. For example, the soft mask 245 may be formed by forming a photoresist layer on the second hard mask 242 and patterning the photoresist layer by using a lithography process. Then, a portion of an upper surface of the second hard mask 242 may be exposed between nano patterns of the soft mask 245.

The first hard mask 240 may include an oxide mask material with high selectivity to the semiconductor material of the first semiconductor layer210 and second semiconductor layer 230. The first hard mask 240 may have a thickness of about 1/5 to about 1/10 of a thickness between the first semiconductor layer 210 and the second semiconductor layer 230 or a thickness between the first semiconductor layer 210 and the contact layer 232. For example, the first hard mask 240 may have a thickness of about 200 nm to about 2 µm. The second hard mask 242 may include a metal mask material with higher selectivity than that of the material of the first hard mask 240. The second hard mask 242 may have a thickness of about 1/5 to about 1/8 of the thickness of the first hard mask 240. For example, the second hard mask 242 may be formed to have a thickness of about 25 nm to about 400 nm considering the selectivity to the first hard mask 240 and the thickness of the first hard mask 240. For example, the first hard mask 240 may include SiO₂, and the second hard mask 242 may include chromium (Cr), aluminum (Al), tungsten (W), titanium (Ti), silver (Ag), or gold (Au).

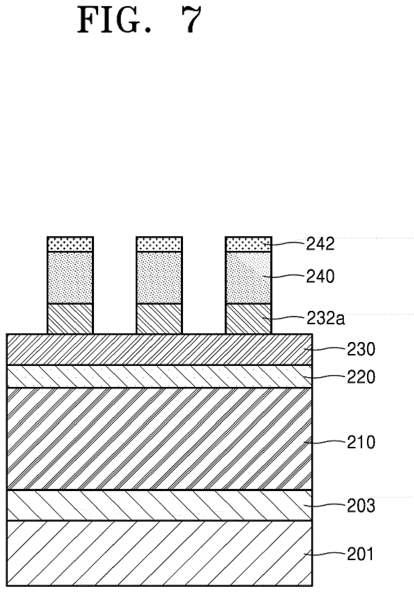

Referring to FIG. 7, the second hard mask 242 exposed between adjacent nano patterns of the soft mask 245 may be etched. The second hard mask 242 may be etched by using, for example, a chlorine-based gas as an etchant gas, and by using inductive coupled plasma (ICP) equipment or reactive ion etching (RIE) equipment in a dry etching manner. The patterns of the second hard mask 242 may have a shape of two-dimensionally arranged circular dots, and the first hard mask 240 may be partially exposed between adjacent patterns of the second hard mask 242, thereby etching the first hard mask 240. The first hard mask 240 may be etched by using, for example, a fluorine-based gas or an argon (Ar) gas as an etchant gas, and by using ICP equipment or RIE equipment in a dry etching manner. For example, a mixed gas of CF₄ and CHF₃, or a mixed gas of CF₃ and Ar, or an Ar gas alone may be used as the etchant gas. Referring to FIG. 7, the contact layer 232 is etched by using the first hard mask 240, and thus, a contact 232a may be formed.

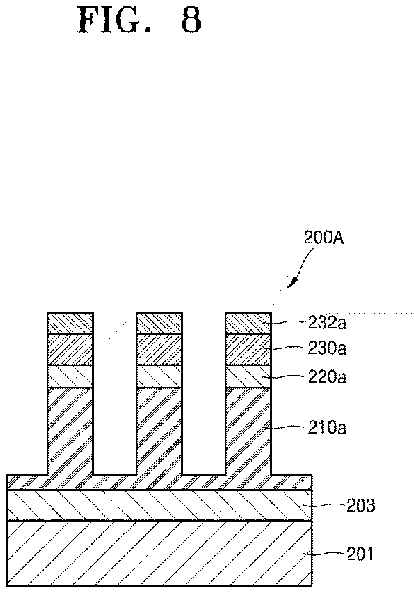

Referring to FIG. 8, a plurality of nanorod light-emitting devices may be formed by partially dry etching the second semiconductor layer 230, the active layer 220, and the first semiconductor layer 210 using the first hard mask 240. Each nanorod light-emitting device may include a first semiconductor layer 210a, an active layer 220a, and a second semiconductor layer 230a, each having a nano sized diameter. For example, etching may be performed by using a chlorine-based gas as an etchant gas and supplying hydrogen H₂, nitrogen N₂, argon Ar, or a mixed gas thereof, which serves for plasma ignition and as an activator, to a chamber. The etching may be performed until a lower portion of the first semiconductor layer 210a is exposed. Alternatively, the etching may be performed until the sacrificial layer 203 is exposed.

Then, the remaining first hard mask 240 and second hard mask 242 may be removed. Then, a plurality of nanorod light-emitting devices may be formed all at once on the substrate 201 and the sacrificial layer 203. The dry etching described above may be performed only on a portion of the first semiconductor layer 210a, and the etching may be stopped in the lower portion of the first semiconductor layer 210a. Then, a lower area of the first semiconductor layer 210a may be left without being completely etched. In this case, the lower portion of the first semiconductor layer 210a may extend laterally along an upper surface of the sacrificial layer 203 to be connected to each other. After the dry etching process, the diameter of a nanorod light-emitting device may be made further uniform in the height direction through a wet process using, for example, a KOH solution or tetramethyl ammonium hydroxide (TMAH) solution.

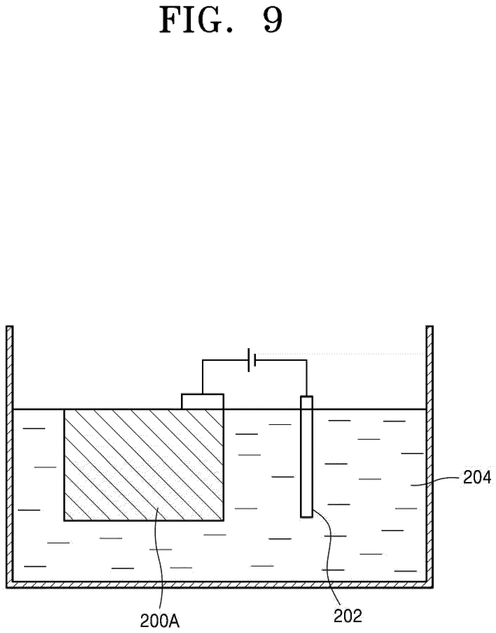

Next, FIG. 9 is a schematic view of electrochemical etching device.

A structure 200A illustrated in FIG. 8 may be immersed in an electrolyte solution 204. For example, about 0.2 M oxalic acid solution or about 0.3 M sodium nitrate (NaNOs) solution is used as the electrolyte solution 204. Thereafter, a positive voltage may be applied to the structure 200A, and a negative voltage may be applied to the electrolyte solution 204. A negative pole 202 may be immersed in the electrolyte solution 204. The material of the negative pole 202 may include, for example, platinum (Pt).

According to an electrochemical etching method of one or more example embodiments, etching may be performed by immersing a sample to be etched in a particular solvent and connecting electrodes to the sample and the solvent to generate carriers by an external bias. In the electrochemical etching method, a method of connecting an electrode directly to a sample may be employed, or a method of connecting an electrode indirectly by using two chambers may be employed.

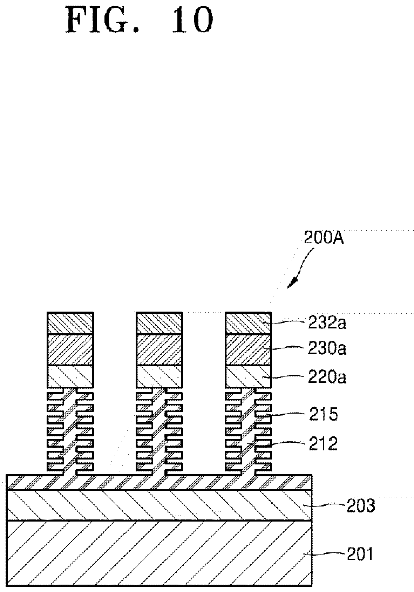

When a voltage is applied to the structure 200A to which an electrode is connected, selective etching may be performed in the first semiconductor layer 210a under a specific condition. By selectively applying a voltage, etching may be performed in the side portion of the first semiconductor layer 210a with relatively excellent carrier confinement. The depth of etching may be adjusted by an etching time and a voltage. For example, a voltage of 10 V to 20 V may be applied for 5 min to 20 min. An etchant may include, for example, at least one of KOH, NaOH, HCl, C₂H₂O₄, H₂SO₄, HNO₃, and HF. Referring to FIG. 10, a plurality of nano pores 215 are formed as the first semiconductor layer 210 is selectively etched, and a core rod 212 may be formed at the center portion of the first semiconductor layer 210.

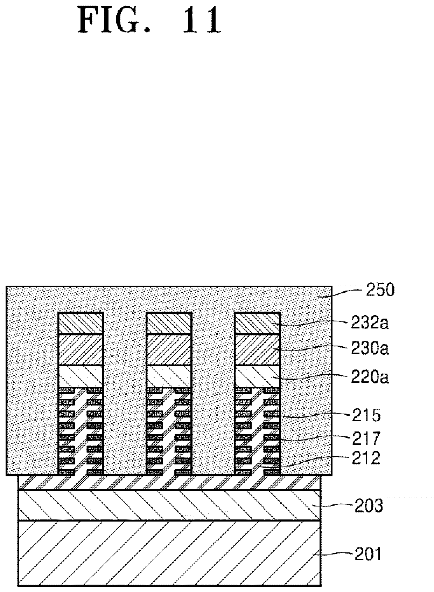

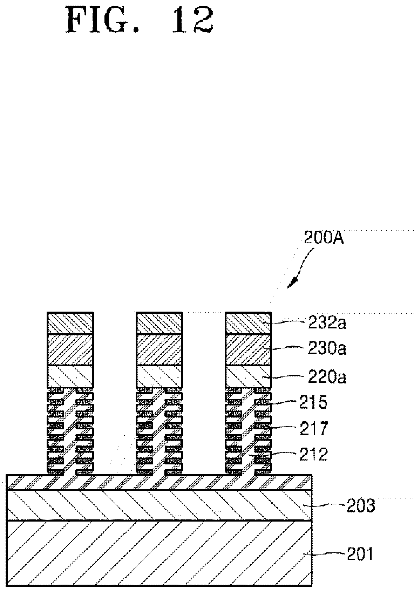

Referring to FIG. 11, the structure 200A of FIG. 10 including the nano pores 215 formed therein is immersed in a liquid 250 containing quantum dots. Then, as illustrated in FIG. 12, the quantum dots 217 may fill the inside of the nano pores 215. Filling the nano pores 215 with quantum dots may include a dipping method or a spin coating method. Each of the quantum dots 217 may have a diameter of 5 nm to 7 nm. When the nano pores 215 are filled with the quantum dots 217, a scattering effect of light incident on the first semiconductor layer 210a is increased so that color conversion efficiency may be increased.

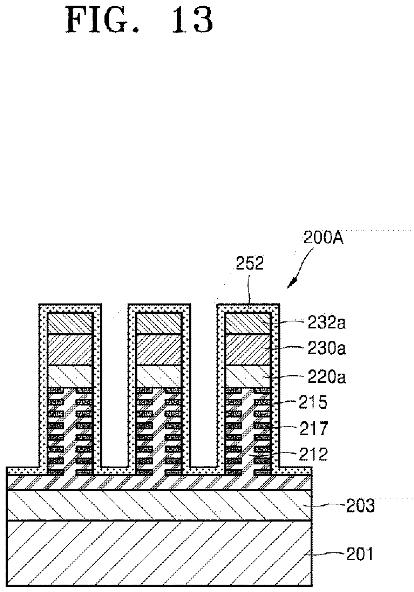

Referring to FIG. 13, a passivation film 252 may be formed on the surface of the structure 200A to have a uniform thickness. The passivation film 252 may be formed by an atomic layer deposition method. The passivation film 252 may protect a nanorod light-emitting device from external physical chemical shocks and prevent the leakage of current by insulating the nanorod light-emitting device. For example, the passivation film 252 may include an insulating material.

Alternatively, the passivation film 252 may include an insulating crystal material having the same crystal structure as the crystal structure of the active layer 220a. The passivation film 252 may have a lattice matching epitaxy relationship or a domain matching epitaxy relationship with the active layer 220a. The passivation film 252 may include, for example, at least one of ZrO, SrO, MgO, BaO, CeO₂, Gd₂O₃, CaO, HfO₂, TiO₂, AlOₓ, BaN, SiN, TiN, CeN, AlN, ZnSe, ZnS, AlGaN, and AlₓGa₁₋ₓAs (x ≥ 0.9).

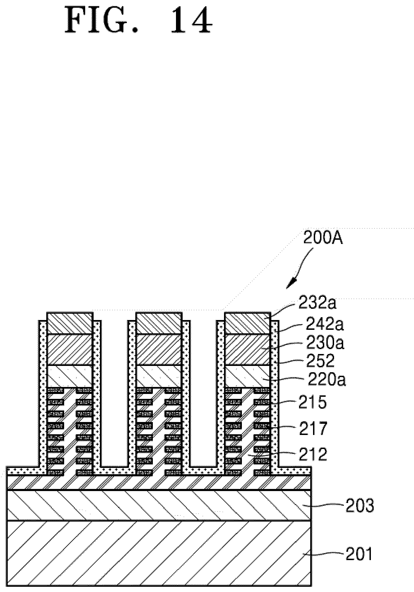

Referring to FIG. 14, the passivation film 252 remaining on the upper surface of the structure 200A may be removed through dry etching. The remaining passivation film 252 may surround the side wall of the structure 200A. The nanorod light-emitting device may be individually separated from the structure 200A by removing or dicing the sacrificial layer 203.

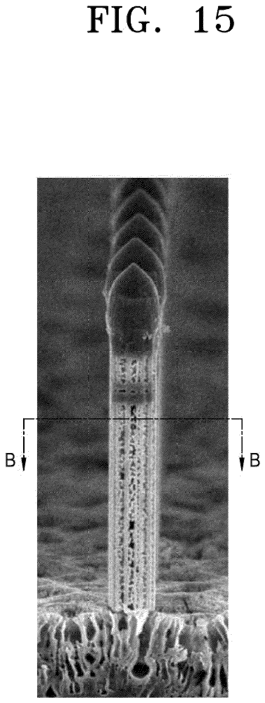

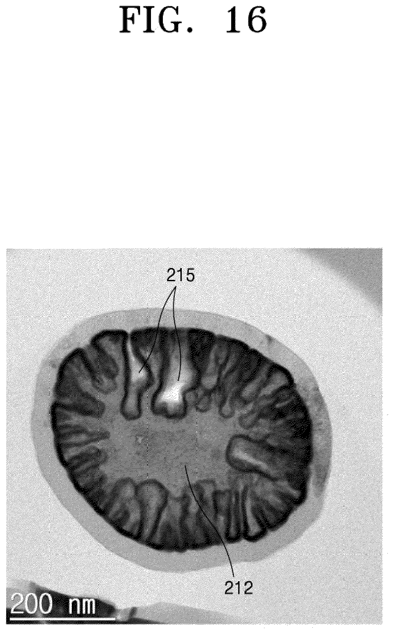

FIG. 15 is an image showing a nanorod light-emitting device manufactured by the manufacturing method described above. FIG. 16 is an image showing a cross-section of the nanorod light-emitting device taken along line B-B of FIG. 15. Referring to FIG. 16, the nano pores 215 are radially provided, and the core rod 212 without the nano pores 215 is provided. The core rod 212 may serve as a path through which current supplied to the nanorod light-emitting device flows, and thus, electrical stability may be secured. Furthermore, as the core rod 212 is provided at the center portion of the first semiconductor layer 210a of the nanorod light-emitting device, structural stability may be secured. Furthermore, the wavelength of light emitted from the active layer 220a is converted by the quantum dots 217 encapsulated in the nano pores 215 so that the nanorod light-emitting device may have EQE of 10% or more.

By cutting the substrate 201 and the sacrificial layer 203 in a vertical direction, each nanorod light-emitting device may be used in a state in which the substrate 201 and the sacrificial layer 203 are attached to each nanorod light-emitting device. Alternatively, the substrate 201 and the sacrificial layer 203 are cut in the vertical direction such that two or more nanorod light-emitting devices are left, two or more nanorod light-emitting devices may be used together.

For example, an AlGaInP red LED exhibits high luminous efficiency in a size of 100 µm x 100 µm or more, but as the size decreases, the efficiency is drastically reduced. For example, EQE may be less than 0.5%. An InGaN red LED is relatively less affected by the size compared with the AlGaInP red LED, but the In content increases to about 35% at a 630 nm wavelength so that IQE and EQE may be reduced to 20% or less and 5% or less, respectively, due to a lattice mismatch. In contrast, in the nanorod light-emitting device according to one or more embodiments, EQE of 10% or more may be secured even in a nano size.

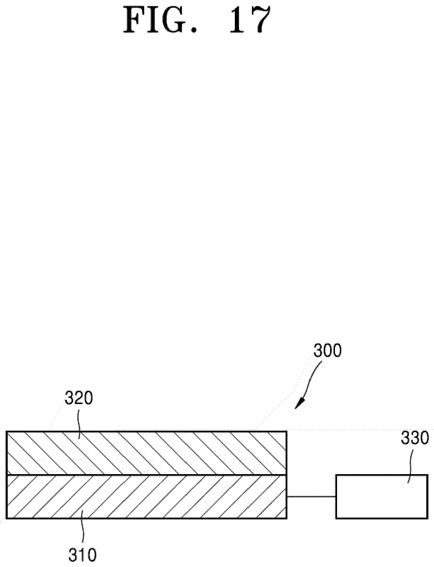

FIG. 17 is a schematic view of a display apparatus 300 according to one or more embodiments. The display apparatus 300 may include a display substrate 310 including a driving circuit, an array layer 320 provided on the display substrate 310, and a controller 330 for inputting an image signal to the display substrate 310. The driving circuit may include at least one transistor and at least one capacitor. A plurality of nanorod light-emitting devices may be arranged on the array layer 320.

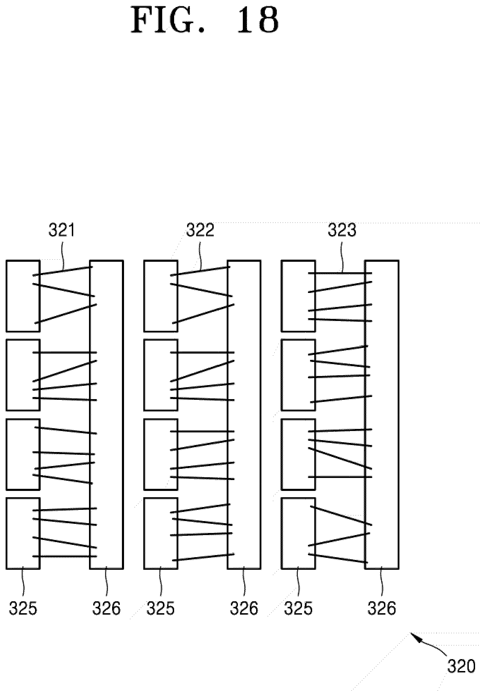

FIG. 18 illustrates the array layer 320.

A plurality of first nanorod light-emitting devices 321, a plurality of second nanorod light-emitting devices 322, and a plurality of third nanorod light-emitting devices 323 are arranged on the array layer 320, The first nanorod light-emitting devices 321, the second nanorod light-emitting devices 322, the third nanorod light-emitting devices 323 may be used as light-emitting elements of pixels of a next-generation display apparatus. The descriptions with reference to FIG. 1, FIG. 2, FIG. 3, and FIG. 4 may be applied to the first nanorod light-emitting devices 321, the second nanorod light-emitting devices 322, and the third nanorod light-emitting devices 323. The array layer 320 may include a plurality of pixel electrodes 325, a common electrode 326 corresponding to the pixel electrodes 325, and the first nanorod light-emitting devices 321, the second nanorod light-emitting devices 322, and the third nanorod light-emitting devices 323 connected between each of the pixel electrodes 325 and the common electrode 326.

For example, the first nanorod light-emitting devices 321 may be configured to emit blue light, the second nanorod light-emitting devices 322 may be configured to emit green light, and the third nanorod light-emitting devices 323 may be configured to emit red light.

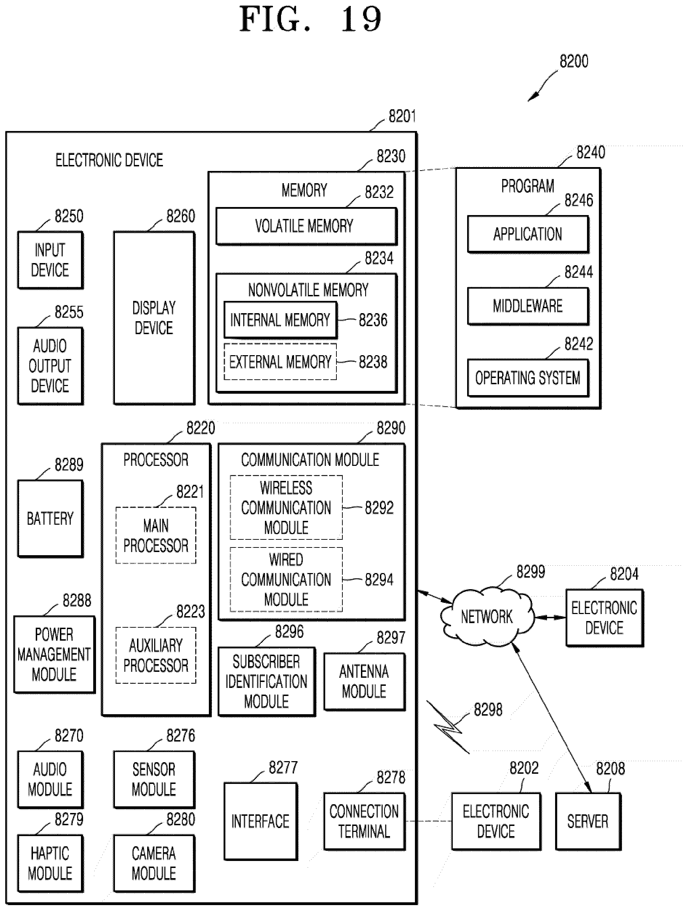

FIG. 19 is a block diagram of an electronic device 8201 including a display apparatus according to one or more embodiments.

Referring to FIG. 19, an electronic device 8201 may be provided in a network environment 8200. In the network environment 8200, the electronic device 8201 may communicate with another electronic device 8202 through a first network 8298 (a short-range wireless communication network, etc.), or may communicate with another electronic device 8204 and/or a server 8208 through a second network 8299 (long-range wireless communication network, etc.). The electronic device 8201 may communicate with another electronic device 8204 through the server 8208. The electronic device 8201 may include a processor 8220, a memory 8230, an input device 8250, an audio output device 8255, a display device (apparatus) 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. In the electronic device 8201, some of the elements may be omitted or another element may be added. Some of these elements may be implemented as one integrated circuit. For example, the sensor module 8276 (a fingerprint sensor, an iris sensor, an illuminance sensor, etc.) may be implemented by being embedded in the display device 8260 (a display, etc.).

The processor 8220 may control, by executing software (a program 8240, etc.), one or a plurality of other elements (a hardware or software element, etc.) of the electronic device 8201, and perform various data processing or operations. As part of data processing or operations, the processor 8220 may load commands and/or data received from other elements (the sensor module 8276, the communication module 8290, etc.) in a volatile memory 8232, process the command and/or data stored in the volatile memory 8232, and store resultant data in a non-volatile memory 8234. The non-volatile memory 8234 may include an internal memory 8236 and an external memory 8238. The processor 8220 may include a main processor 8221 (a central processing unit, an application processor, etc.) and an auxiliary processor 8223 (a graphics processing unit, an image signal processor, a sensor hub processor, a communication processor, etc.), which are operable independently or together The auxiliary processor 8223 may consume less power than the main processor 8221 and may perform a specialized function.

The auxiliary processor 8223 may control functions and/or states related to some elements (the display device 8260, the sensor module 8276, the communication module 8290, etc.) of the electronic device 8201, instead of the main processor 8221 when the main processor 8221 is in an inactive state (a sleep state), or with the main processor 8221 when the main processor 8221 is in an active state (an application execution state). The auxiliary processor 8223 (an image signal processor, a communication processor, etc.) may be implemented as a part of functionally related other elements (the camera module 8280, the communication module 8290, etc.).

The memory 8230 may store various pieces of data needed for element (the processor 8220, the sensor module 8276, etc.) of the electronic device 8201. The data may include, for example, software (the program 8240, etc.) and input data and/or output data regarding commands related thereto. The memory 8230 may include the volatile memory 8232 and/or the non-volatile memory 8234.

The program 8240 may be stored as software in the memory 8230, and may include an operating system 8242, a middleware 8244, and/or an application 8246.

The input device 8250 may receive commands and/or data to be used in the elements (the processor 8220, etc.) of the electronic device 8201, from the outside (a user, etc.) of the electronic device 8201. The input device 8250 may include a remote controller, a microphone, a mouse, a keyboard, and/or a digital pen (a stylus pen, etc.).

The audio output device 8255 may output an audio signal to the outside of the electronic device 8201. The audio output device 8255 may include a speaker and/or a receiver. The speaker may be used for general purposes such as multimedia playback or recording playback, and the receiver may be used to receive incoming calls. The receiver may be combined as a part of the speaker or implemented as an independent separate device.

The display device 8260 may visually provide information to the outside of the electronic device 8201. The display device 8260 may include a display, a hologram device, or a projector, and a control circuit for controlling such a device. The display device 8260 may include a display device according to one or more embodiments. The display device 8260 may include a touch circuitry set to sense a touch, and/or a sensor circuit (a pressure sensor, etc.) set to measure the strength of a force generated by the touch.

The audio module 8270 may convert sound into an electrical signal or reversely an electrical signal into sound. The audio module 8270 may obtain sound through the input device 8250, or output sound through the audio output device 8255 and/or a speaker and/or a headphone of another electronic device (another electronic device 8202, etc.) connected to the electronic device 8201 in a wired or wireless manner.

The sensor module 8276 may sense an operation state (power, a temperature, etc.) of the electronic device 8201, or an external environment state (a user state, etc.), and generate an electrical signal and/or data value corresponding to a sensed state. The sensor module 8276 may include a gesture sensor, a gyro sensor, a barometric sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more designated protocols to be used for connecting the electronic device 8201 to another electronic device (another electronic device 8202, etc.) in a wired or wireless manner. The interface 8277 may include a high definition multimedia interface (HDMI), a universal serial bus (USB) interface, an SD card interface, and/or an audio interface.

A connection terminal 8278 may include a connector for physically connecting the electronic device 8201 to another electronic device (another electronic device 8202, etc.). The connection terminal 8278 may include an HDMI connector, a USB connector, an SD card connector, and/or an audio connector (a headphone connector, etc.).

The haptic module 8279 may convert electrical signals into mechanical stimuli (vibrations, movements, etc.) or electrical stimuli that are perceivable by a user through tactile or motor sensations. The haptic module 8279 may include a motor, a piezoelectric device, and/or an electrical stimulation device.

The camera module 8280 may capture a still image and a video. The camera module 8280 may include a lens assembly including one or a plurality of lenses, image sensors, image signal processors, and/or flashes. The lens assembly included in the camera module 8280 may collect light emitted from an object that is a target for image capturing.

The power management module 8288 may manage power supplied to the electronic device 8201. The power management module 8288 may be implemented as a part of a power management integrated circuit (PMIC).

The battery 8289 may supply power to the constituent elements of the electronic device 8201. The battery 8289 may include non-rechargeable primary cells, rechargeable secondary cells, and/or fuel cells.

The communication module 8290 may establish a wired communication channel and/or a wireless communication channel between the electronic device 8201 and another electronic device (another electronic apparatus 8202, another electronic device 8204, the server 8208, etc.), and support a communication through an established communication channel. The communication module 8290 may be operated independently of the processor 8220 (the application processor, etc.), and may include one or a plurality of communication processors supporting a wired communication and/or a wireless communication. The communication module 8290 may include a wireless communication module 8292 (a cellular communication module, a short-range wireless communication module, a global navigation satellite system (GNSS) communication module, etc.), and/or a wired communication module 8294 (a local area network (LAN) communication module, a power line communication module, etc.). Among the above communication modules, a corresponding communication module may communicate with another electronic device through the first network 8298 (a short-range communication network such as Bluetooth, WiFi Direct, or infrared data association (IrDA)) or the second network 8299 (a long-range communication network such as a cellular network, the Internet, or a computer network (LAN, WAN, etc.)). These various types of communication modules may be integrated into one constituent element (a single chip, etc.), or may be implemented as a plurality of separate constituent elements (multiple chips). The wireless communication module 8292 may verify and authenticate the electronic device 8201 in a communication network such as the first network 8298 and/or the second network 8299 by using subscriber information (an international mobile subscriber identifier (IMSI), etc.) stored in the subscriber identification module 8296.

The antenna module 8297 may transmit signals and/or power to the outside (another electronic device, etc.) or receive signals and/or power from the outside. An antenna may include an emitter formed in a conductive pattern on a substrate (a printed circuit board (PCB), etc.). The antenna module 8297 may include one or a plurality of antennas. When the antenna module 8297 includes a plurality of antennas, the communication module 8290 may select, from among the antennas, an appropriate antenna for a communication method used in a communication network such as the first network 8298 and/or the second network 8299. Signals and/or power may be transmitted or received between the communication module 8290 and another electronic device through the selected antenna. Other parts (an RFIC, etc.) than the antenna may be included as a part of the antenna module 8297.

Some of the constituent elements may be connected to each other through a communication method between peripheral devices (a bus, general purpose input and output (GPIO), a serial peripheral interface (SPI), a mobile industry processor interface (MIPI), etc.) and may mutually exchange signals (commands, data, etc.).

The command or data may be transmitted or received between the electronic device 8201 and the external electronic device 8204 through the server 8208 connected to the second network 8299. The electronic devices 8202 and 8204 may be of a type that is the same as or different from the electronic device 8201. All or a part of operations executed in the electronic device 8201 may be executed in one or a plurality of the electronic devices (8202, 8204, and 8208). For example, when the electronic device 8201 needs to perform a function or service, the electronic device 8201 may request one or a plurality of electronic devices to perform part of the whole of the function or service, instead of performing the function or service. The one or a plurality of the electronic devices receiving the request may perform additional function or service related to the request, and transmit a result of the performance to the electronic device 8201. To this end, cloud computing, distributed computing, and/or client-server computing technology may be used.

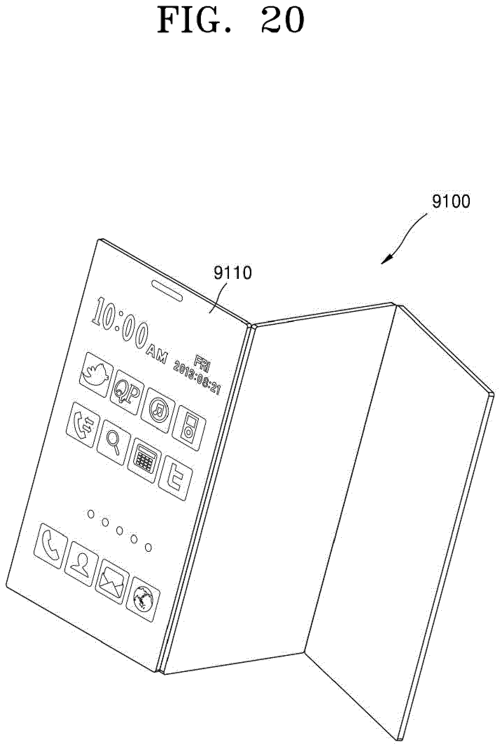

FIG. 20 is a view showing an example in which a display apparatus according to one or more embodiments is applied to a mobile device 9100. The mobile device 9100 may include a display apparatus 9110, and the display apparatus 9110 may include display apparatuses according to embodiments. The display apparatus 9110 may have a foldable structure, for example, multi-foldable structure.

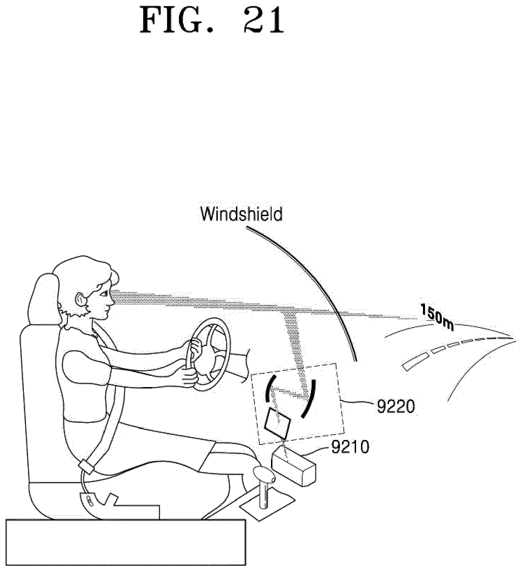

FIG. 21 is a view showing an example in which a display apparatus according to one or more embodiments is applied to a display apparatus for a vehicle. The display apparatus may be a head-up display apparatus 9200 for a vehicle and may include a display 9210 provided in an area of the vehicle and an optical path change member 9220 that changes an optical path so that a driver sees an image generated from the display 9210.

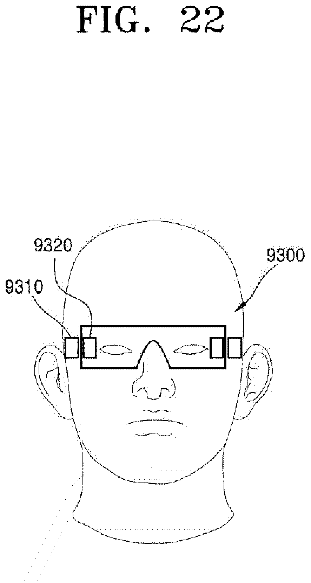

FIG. 22 is a view showing an example in which a display apparatus according to one or more embodiments is applied to augmented reality glasses 9300. The augmented reality glasses 9300 may include a projection system 9310 form forming an image and an element 9320 for guiding an image from the projection system 9310 to be seen by the eyes of a user. The projection system 9310 may include a display apparatus according to one or more embodiments.

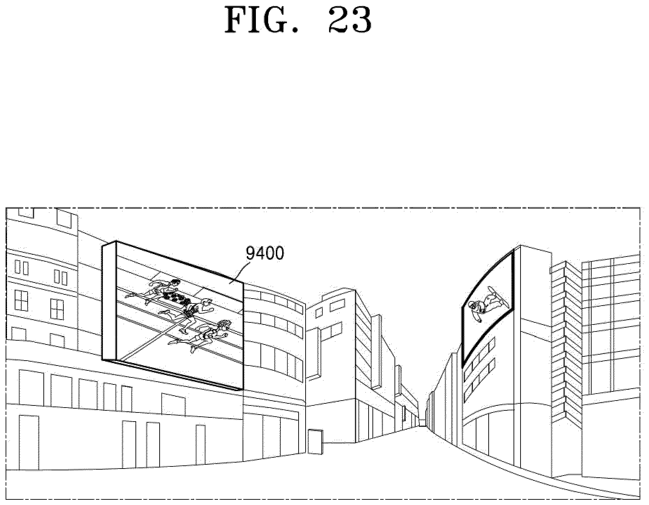

FIG. 23 is a view showing an example in which a display apparatus according to one or more embodiments is applied to a large signage. A signage 9400 may be used for outdoor advertisement using a digital information display, and may control advertisement content and the like through a communication network. The signage 9400 may be implemented, for example, through the electronic apparatus described with reference to FIG. 19.

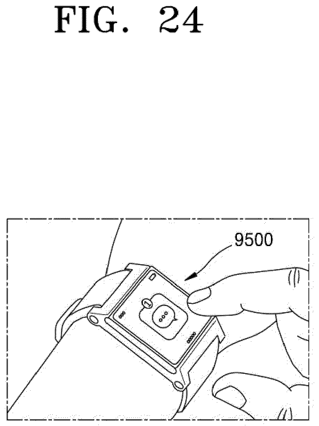

FIG. 24 is a view showing an example in which a display apparatus according to one or more embodiments is applied to a wearable display 9500. The wearable display 9500 according to one or more embodiments may include a display apparatus, and may be implemented through the electronic apparatus described with reference to FIG. 19.

In addition, the display apparatus according to one or more embodiments may be applied to various products, such as a rollable TV, a stretchable display, and the like.

In the nanorod light-emitting device and the display apparatus including the same according to various example embodiments, the quantum dots are included in the nano pores so that external quantum efficiency may be improved. In the method of manufacturing a nanorod light-emitting device according to various example embodiments, the nano pores and the quantum dots are formed on the first semiconductor layer.

It should be understood that the example embodiments described herein should be considered in a descriptive sense only and not for purposes of limitation. Descriptions of features or aspects within each embodiment should typically be considered as available for other similar features or aspects in other embodiments.

While example embodiments have been described with reference to the figures, it will be understood by those of ordinary skill in the art that various changes in form and details may be made therein without departing from the scope as defined by the following claims.

## Claims

1. A nanorod light-emitting device comprising:
an n-type semiconductor layer;
an active layer on the n-type semiconductor layer; and
a p-type semiconductor layer on the active layer,
wherein the n-type semiconductor layer comprises:
a core rod;,
a plurality of nano pores opened in an outward direction from the core rod; and
a plurality of quantum dots in the plurality of nano pores.

2. The nanorod light-emitting device of claim 1, wherein, in a cross-section of the n-type semiconductor layer, the plurality of nano pores are arranged radially from the core rod.

3. The nanorod light-emitting device of claim 1 or 2, wherein, in a vertical cross-section of the n-type semiconductor layer, the plurality of nano pores are arranged in a vertical direction.

4. The nanorod light-emitting device of any preceding claim, wherein the active layer comprises at least one of indium gallium nitride (InGaN) and indium aluminum gallium nitride (InAlGaN).

5. The nanorod light-emitting device of any preceding claim, wherein the nanorod light-emitting device has a diameter in a range of 0.5 µm to 2 µm.

6. The nanorod light-emitting device of any preceding claim, wherein the nanorod light-emitting device has a height in a range of 2 µm to 7 µm.

7. The nanorod light-emitting device of any preceding claim, wherein a diameter of the core rod is in a range of 1/3 to 1/5 of a diameter of the nanorod light-emitting device.

8. The nanorod light-emitting device of any preceding claim, wherein a diameter of the core rod is in a range of 120 nm to 200 nm.

9. The nanorod light-emitting device of any preceding claim, wherein the plurality of quantum dots are configured to convert blue light emitted by the active layer into red light.

10. The nanorod light-emitting device of any preceding claim, further comprising a super lattice layer between the n-type semiconductor layer and the active layer.

11. The nanorod light-emitting device of any preceding claim, further comprising a current blocking layer between the active layer and the p-type semiconductor layer.

12. The nanorod light-emitting device of any preceding claim, wherein each of the plurality of nano pores has a first length in a diametric direction of the n-type semiconductor layer and a second length in a direction perpendicular to the diametric direction, and the first length is greater than the second length.

13. A display apparatus comprising:
a plurality of pixel electrodes;
a common electrode corresponding to the plurality of pixel electrodes;
a plurality of nanorod light-emitting devices according to any preceding claim connected between each of the plurality of pixel electrodes and the common electrode; and
a driving circuit layer configured to drive the plurality of nanorod light-emitting devices.

14. A method of manufacturing a nanorod light-emitting device, the method comprising:
forming an n-type semiconductor layer on a substrate;
forming an active layer on the n-type semiconductor layer;
forming a p-type semiconductor layer on the active layer;
forming a plurality of nanorod light-emitting structures by patterning the n-type semiconductor layer, the active layer, and the p-type semiconductor layer in a form of a plurality of nanorods;
forming, by an electrochemical etching process and on the n-type semiconductor layer having the plurality of nanorod light-emitting structures, a core rod and a plurality of nano pores opened in an outward direction from the core rod; and
encapsulating quantum dots in the plurality of nano pores.

15. The method of claim 14, wherein, in a cross-section of the n-type semiconductor layer, the plurality of nano pores are arranged radially from the core rod.
